# EUROPÄISCHE PATENTSCHRIFT

(11) **EP 3 055 448 B1**
(45) Veröffentlichungstag und Bekanntmachung des Hinweises auf die Patenterteilung: **01.01.2020**
(21) Anmeldenummer: 14781551.8
(22) Anmeldetag: 08.10.2014
(51) Int. Cl.: C30B 33/06, B23K 26/50, H01L 21/762, B23K 26/53, B23K 103/00

(54) **KOMBINIERTES HERSTELLUNGSVERFAHREN ZUM ABTRENNEN MEHRERER DÜNNER FESTKÖRPERSCHICHTEN VON EINEM DICKEN FESTKÖRPER**
COMBINED PRODUCTION METHOD FOR REMOVING A PLURALITY OF THIN SOLID-BODY LAYERS FROM A THICK SOLID BODY
PROCÉDÉ DE PRODUCTION COMBINÉ PERMETTANT DE SÉPARER PLUSIEURS COUCHES DE SOLIDE MINCES À PARTIR D'UN SOLIDE ÉPAIS

(30) Priorität: 08.10.2013 DE 102013016669
(43) Veröffentlichungstag der Anmeldung: 17.08.2016
(73) Patentinhaber: Siltectra GmbH, 01099 Dresden (DE)
(72) Erfinder: DRESCHER, Wolfram, 01099 Dresden (DE); RICHTER, Jan, 01277 Dresden (DE)
(74) Vertreter: Müller Hoffmann & Partner
(86) Internationale Anmeldenummer: PCT/EP2014/071506
(87) Internationale Veröffentlichungsnummer: WO 2015/052216

(56) Entgegenhaltungen:
- EP-A1- 0 533 551
- EP-A1- 2 551 897
- WO-A1-2013/166381
- WO-A2-2008/082723
- WO-A2-2009/061353
- WO-A2-2013/126927
- DE-A1-102009 005 303
- US-A1- 2004 135 467
- US-A1- 2007 249 140
- US-A1- 2012 234 887

## Beschreibung

Die vorliegende Erfindung bezieht sich auf ein Verfahren zum Herstellen von Festkörperschichten gemäß dem Gegenstand von Anspruch 1.

In vielen technischen Bereichen (z.B. Mikroelektronik- oder Photovoltaiktechnologie) werden Materialien, wie z.B. Silizium, Germanium oder Saphir, häufig in der Form dünner Scheiben und Platten (so genannte Wafer) gebraucht. Standardmäßig werden solche Wafer derzeit durch Sägen aus einem Ingot hergestellt, wobei relativ große Materialverluste ("kerf-loss") entstehen. Da das verwendete Ausgangsmaterial oft sehr teuer ist, gibt es starke Bestrebungen, solche Wafers mit weniger Materialaufwand und damit effizienter und kostengünstiger herzustellen.

Beispielsweise gehen mit den derzeit üblichen Verfahren allein bei der Herstellung von Siliziumwafer für Solarzellen fast 50% des eingesetzten Materials als "kerf-loss" verloren. Weltweit gesehen entspricht dies einem jährlichen Verlust von über 2 Milliarden Euro. Da die Kosten des Wafers den größten Anteil an den Kosten der fertigen Solarzelle ausmachen (über 40%), könnten durch entsprechende Verbesserungen der Waferherstellung die Kosten von Solarzellen signifikant reduziert werden.

Besonders attraktiv für eine solche Waferherstellung ohne kerf-loss ("kerf-free wafering") erscheinen Verfahren, die auf das herkömmliche Sägen verzichten und z.B. durch Einsatz von temperaturinduzierten Spannungen direkt dünne Wafer von einem dickeren Werkstück abspalten können. Dazu gehören insbesondere Verfahren, wie sie z.B. in PCT/US2008/012140 und PCT/EP2009/067539 beschrieben sind. Alternative Verfahren werden z.B. durch die Druckschriften WO2013/126927A2, US2012/234887A1, WO2008/082723A2, US2007/249140A1, WO2009/061353A2, DE102009005303A1 oder US2004/135467A1 offenbart. Gemäß PCT/US2008/012140 und PCT/EP2009/067539 wird zum Erzeugen dieser Spannungen eine auf das Werkstück aufgetragene Polymerschicht verwendet.

Die Polymerschicht weist bei den erwähnten Verfahren einen im Vergleich zum Werkstück um ungefähr zwei Größenordnungen höheren thermischen Ausdehnungskoeffizienten auf. Außerdem kann durch Ausnutzen eines Glasübergangs ein relativ hoher Elastizitätsmodul in der Polymerschicht erreicht werden, so dass im Schichtsystem Polymerschicht-Werkstück durch Abkühlen genügend große Spannungen induziert werden können, um die Abspaltung von Wafer vom Werkstück zu ermöglichen.

Beim Abspalten eines Wafers vom Werkstück haftet bei den erwähnten Verfahren jeweils auf einer Seite des Wafers noch Polymer an. Der Wafer krümmt sich dabei sehr stark in Richtung dieser Polymerschicht, was ein kontrolliertes Abspalten erschwert, und z.B. zu Dickenschwankungen des abgespaltenen Wafers führen kann. Außerdem erschwert die starke Krümmung die weitere Verarbeitung und kann sogar zum Zerbrechen des Wafers führen.

Bei Verwendung der Verfahren nach bisherigem Stand der Technik weisen die hergestellten Wafer üblicherweise jeweils größere Dickenschwankungen auf, wobei die räumliche Dickenverteilung häufig ein Muster mit vierzähliger Symmetrie zeigt. Die totale Dickenschwankung über den ganzen Wafer gesehen ("total thickness variation", TTV) beträgt bei Verwendung der bisherigen Verfahren häufig mehr als 100% der mittleren Waferdicke (ein Wafer von bspw. 100 Mikrometer mittlerer Dicke, der z.B. an seiner dünnsten Stelle 50 Mikrometer dick und an seiner dicksten Stelle 170 Mikrometer dick ist, hat ein TTV von 170-50=120 Mikrometer, was relativ zu seiner mittleren Dicke einer totalen Dickenschwankung von 120% entspricht). Wafer mit solch starken Dickenschwankungen sind für viele Anwendungen nicht geeignet. Außerdem liegen bei den am häufigsten auftretenden vierzähligen Dickenverteilungsmustern die Bereiche mit den größten Schwankungen unglücklicherweise in der Mitte des Wafers, wo sie am meisten stören.

Außerdem entstehen beim Verfahren nach aktuellem Stand der Technik während der Bruchpropagation beim Abspalten selbst unerwünschte Oszillationen in den beteiligten Schichtsystemen, die den Verlauf der Bruchfront ungünstig beeinflussen und insbesondere zu signifikanten Dickenschwankungen des abgespaltenen Wafers führen können.

Zudem ist es bei den bisherigen Verfahren schwierig, einen reproduzierbar guten Wärmekontakt über die ganze Fläche der Polymerschicht sicherzustellen. Lokal ungenügender Wärmekontakt kann aber aufgrund der geringen thermischen Leitfähigkeit der verwendeten Polymere zu ungewollten, signifikanten lokalen Temperaturabweichungen im Schichtsystem führen, was sich seinerseits negativ auf die Kontrollierbarkeit der erzeugten Spannungsfelder und damit die Qualität der hergestellten Wafer auswirkt.

Ein alternatives Verfahren, das ebenfalls ohne Sägen auskommt, wird durch die Druckschrift DE 692 31 328 T2 beschrieben. Gemäß dieser Druckschrift werden mittels einer Ionenimplantation H⁺-Ionen mit 150 keV in eine monokristalline Siliciumplatte eingebracht. Die H⁺-Ionen werden dabei derart gesteuert in die Siliciumplatte eingebracht, dass sie im Wesentlichen auf einer definierten Ebene innerhalb der Platte zum Liegen kommen. Die Dosis der dabei implantierten H⁺-Ionen ist dabei größer als 10¹⁶cm⁻², wodurch infolge einer Erhitzung der Siliciumplatte auf eine Temperatur von größer 500°C eine Koaleszenz der eingebrachten Ionen bewirkt wird, was zu einer Abtrennung der die Ebene der eingebrachten Ionen benachbarenden Anteile der Siliciumplatte führt.

Dieses Verfahren ist sehr Kostenintensiv und komplex, da eine äußerst aufwendige lonenkanone mit entsprechender Steuereinrichtung bereitgestellt werden muss. Weiterhin dauert die Implantation der Ionen aufgrund der hohen Dosis recht lange. Ferner erfordert das Aufheizen der Siliciumplatte eine hohe Energieaufbringung und verhindert, dass elektrische Bauteile, die bei so hohen Temperaturen beschädigt werden, vor dem Erhitzen an der Siliciumplatte angeordnet werden.

Es ist somit die Aufgabe der vorliegenden Erfindung ein Verfahren zur Herstellung von Festkörperschichten bereitzustellen, das die kostengünstige Herstellung von Festkörperplatten bzw. Wafern mit einer gleichmäßigen Dicke ermöglicht, insbesondere mit einem TTV von weniger als 120 Mikrometer.

Die zuvor genannte Aufgabe wird durch ein Verfahren gemäß Anspruch 1 zum Herstellen von Festkörperschichten gelöst.

Der Schritt des Erzeugens einer Ablöseebene und der Schritt des Aufbringens einer weiteren Aufnahmeschicht sowie der Schritt des thermischen Beaufschlagens der an dem Festkörper angeordneten Polymerschicht zum, insbesondere mechanischen, Erzeugen von Spannungen in dem Festkörper ist beliebig oft wiederholbar bzw. durchführbar. Bevorzugt werden mittels des erfindungsgemäßen Verfahren mehr als oder genau drei, vier, fünf, sechs, sieben, acht, neun, zehn, fünfzehn, zwanzig, fünfundzwanzig oder dreißig Festkörperschichten bzw. Wafer von dem Festkörper abgetrennt. Lediglich die Dicke bzw. axiale Länge des Festkörpers und die Dicken bzw. axialen Längen der abgetrennten Schichten geben dabei eine Begrenzung der maximalen Wiederholungsanzahl vor.

Diese Lösung ist vorteilhaft, da von einem Festkörper auf vorteilhafte Weise mehrere Festkörperschichten abtrennbar insbesondere abspaltbar sind. Die Einbringung bzw. Erzeugung von Defekten bewirkt eine Erzeugung einer Sollbrucheben bzw. eine Führung für einen mittels der Spannungen ausgelösten und/oder geführten Riss. Der TTV der erzeugten Festkörperschichten ist durch das erfindungsgemäße Verfahren soweit reduzierbar, dass mehr Festkörperschichten aus einem Festkörper gewonnen werden können.

Weitere bevorzugte Ausführungsformen sind Gegenstand der Unteransprüche und der nachfolgenden Beschreibung.

Die Spannungen zum Ablösen der Festkörperschicht werden gemäß einer bevorzugten Ausführungsform der vorliegenden Erfindung von dem Festkörper durch die thermische Beaufschlagung der jeweiligen Aufnahmeschicht, insbesondere der jeweiligen Polymerschicht, erzeugt. Die thermische Beaufschlagung stellt bevorzugt ein Abkühlen der Aufnahmeschicht bzw. Polymerschicht auf oder unter die Umgebungstemperatur und bevorzugt unter 10°C und besonders bevorzugt unter 0°C und weiter bevorzugt unter -10°C dar. Die Abkühlung der Polymerschicht/en erfolgt höchst bevorzugt derart, dass zumindest ein Teil der Polymerschicht, die bevorzugt aus PDMS besteht, einen Glasübergang vollzieht. Die Abkühlung kann hierbei eine Abkühlung auf unter -100°C sein, die z.B. mittels flüssigen Stickstoffs bewirkbar ist. Diese Ausführungsform ist vorteilhaft, da sich die Polymerschicht in Abhängigkeit von der Temperaturveränderung zusammenzieht und/oder einen Gasübergang erfährt und die dabei entstehenden Kräfte auf den Festkörper überträgt, wodurch mechanische Spannungen in dem Festkörper erzeugbar sind, die zum Auslösen eines Risses und/oder zur Rissausbreitung führen, wobei sich der Riss zunächst entlang der ersten Ablöseebene zum Abspalten der Festkörperschicht ausbreitet.

Gemäß einer bevorzugten Ausführungsform der vorliegenden Erfindung erfolgt jeweils nach dem Schritt des thermischen Beaufschlagens der Polymerschicht zum Erzeugen von Spannungen zum Ablösen der ersten Festkörperschicht und vor dem Schritt des Einbringens oder Erzeugens von Defekten in den Festkörper zum Vorgeben einer zweiten Ablöseebene eine spanende Bearbeitung der durch das Abtrennen der ersten Festkörperschicht freigelegten Oberfläche des Festkörpers. Dieser Bearbeitungsschritt kann stets nach dem thermischen Beaufschlagen der Polymerschicht zum Erzeugen von Spannungen zum Ablösen einer Festkörperschicht und vor dem Einbringen oder Erzeugen von Defekten in den Festkörper zum Vorgeben einer weiteren Ablöseebene erfolgen. Aufgrund des vorteilhaften erfindungsgemäßen Verfahrens sind, wenn überhaupt, nur sehr geringe Bestandteile des Festkörpers nachzubearbeiten bzw. abzuschleifen. Dennoch führt dieser Bearbeitungsschritt zu einer sehr ebenen Oberfläche und somit zu einer verbesserten Einbringung bzw. Erzeugung der Defekte innerhalb der Struktur des Festkörpers.

Die Einbringung von Defekten wird gemäß einer weiteren bevorzugten Ausführungsform der vorliegenden Erfindung durch die Einbringung von Ionen bewirkt wird, wobei eine Strahlungsquelle zum Bereitstellen der in den Festkörper einzubringenden Ionen vorgesehen ist, wobei die Strahlungsquelle derart ausgerichtet ist, dass die von ihr ausgestrahlten Ionen in den Festkörper eindringen. Diese Ausführungsform ist vorteilhaft, da sie in Verbindung mit der spannungsinduzierten Rissausbreitung und Rissauslösung gegenüber einer ausschließlich auf der Implantation von Ionen beruhenden Festkörperschichterzeugung deutlich günstiger, schneller und energieeffizienter ist. Weiterhin können mehr Festkörper aus unterschiedlichen Materialien mit diesem Verfahren in Festkörperschichten geteilt werden, da die Prozesstemperatur deutlich niedriger ist. Ein weiterer Vorteil der Erfindung ist, dass aufgrund der implantierten Ionen die Ablöseebene bzw. eine Defektschicht in dem Festkörper erzeugbar ist, durch die der Riss bei der Rissausbreitung geleitet bzw. geführt wird, was die Realisierung sehr kleiner TTVs, insbesondere kleiner als 100 Mikrometer oder kleiner als 80 Mikrometer oder kleiner als 60 Mikrometer oder kleiner als 40 Mikrometer oder kleiner als 20 Mikrometer oder kleiner als 10 Mikrometer oder kleiner als 5 Mikrometer ermöglicht. Die Ionenimplantation schafft somit eine Art Perforation im Inneren des Festkörpers, entlang der die Rissausbreitung erfolgt bzw. entlang der die Festkörperschicht von dem Festkörper abgetrennt wird. Mindestens oder genau eine Strahlungsquelle ist somit bevorzugt derart ausgerichtet, dass die von ihr ausgestrahlten Ionen in den Festkörper eindringen. Die Strahlungsquelle dient bevorzugt zur Bereitstellung von H⁺-Ionen oder von Edelgasionen, wie z.B. der Stoffe Helium, Neon, Krypton und Xenon, wobei die Ionen der verbleibenden nichtgenannten Edelgase ebenfalls Einsatz finden können. Weiterhin ist denkbar, dass die Ionen der zuvor genannten Stoffe und/oder weiterer Stoffe getrennt oder kombiniert bzw. gleichzeitig oder nacheinander eingesetzt werden.

Der Festkörper wird gemäß einer weiteren bevorzugten Ausführungsform der vorliegenden Erfindung mit einer vorgegebenen Dosis an Ionen beaufschlagt, wobei die vorgegebene Dosis kleiner gleich 5+10¹⁶cm⁻², kleiner als 10¹⁵cm⁻² oder kleiner als 10¹⁴cm⁻² oder kleiner als 10¹³cm⁻² ist. Diese Ausführungsform ist vorteilhaft, da durch die geringe Dosis zwar Defekte innerhalb des Festkörpers erzeugt werden, die eine vorteilhafte Rissführung bewirken, jedoch die Implantationszeit relativ kurz ist. Zusätzlich oder alternativ wird der Festkörper derart temperiert, dass eine Koaleszenz der in den Festkörper eingebrachten Ionen verhindert wird. Eine Koaleszenz bezeichnet im Allgemeinen das Zusammenfließen kolloidaler Teilchen. Als Kolloide werden hierbei Teilchen bzw. Ionen bezeichnet, die im Dispersionsmedium (Festkörper) fein verteilt sind. Diese Ausführungsform ist vorteilhaft, da nicht nur temperaturstabile Festkörper, sondern auch temperaturkritische Festkörper bzw. Festkörper mit temperaturkritischen Bestandteilen, wie z.B. Elektronikbauteilen, die bei Temperaturen von größer 50°C oder größer 100°C oder größer 200°C oder größer 300°C oder größer 400°C oder größer 500°C beschädigt werden, verarbeitet werden können.

Die Erzeugung von Defekten wird gemäß einer weiteren bevorzugten Ausführungsform der vorliegenden Erfindung durch mindestens eine als Laser ausgeführte Strahlenquelle bewirkt, wobei die von der Strahlenquelle ausgestrahlten Strahlen die Defekte an vorbestimmten Orten innerhalb des Festkörpers erzeugen. Diese Ausführungsform ist vorteilhaft, da aufgrund der Strahlungsquelle die Ablöseschicht bzw. Defektschicht in dem Festkörper erzeugbar ist, durch die der Riss bei der Rissausbreitung geleitet bzw. geführt wird, was die sehr präzise Realisierung sehr kleiner TTVs, insbesondere kleiner als 100 Mikrometer oder kleiner als 80 Mikrometer oder kleiner als 60 Mikrometer oder kleiner als 40 Mikrometer oder kleiner als 20 Mikrometer oder kleiner als 10 Mikrometer oder kleiner als 5 Mikrometer ermöglicht. Die Strahlenbeaufschlagung des Wafers bzw. der Festkörperschicht schafft somit eine Art Perforation im Inneren des Festkörpers, entlang der die Rissausbreitung erfolgt bzw. entlang der die Festkörperschicht von dem Festkörper abgetrennt wird.

Die Strahlungsquelle (z.B. als lonenkanone oder Laser ausgeführt) wird gemäß einer weiteren bevorzugten Ausführungsform der vorliegenden Erfindung derart eingestellt, dass die von ihr ausgestrahlten Strahlen zum Erzeugen der Ablöseebene auf eine definierte Tiefe, insbesondere <100µm, in den Festkörper eindringen. Bevorzugt wird die Ablöseebene parallel beabstandet zu einer äußeren und bevorzugt ebenen Oberfläche des Festkörpers ausgebildet. Bevorzugt ist die Ablöseebene weniger als 100 Mikrometer und bevorzugt weniger als 50 Mikrometer und besonders bevorzugt weniger als oder gleich 20, 10, 5 oder 2 Mikrometer von der ebenen Oberfläche des Festkörpers beabstandet innerhalb des Festkörpers ausgebildet.

Der Festkörper weist gemäß einer weiteren bevorzugten Ausführungsform der vorliegenden Erfindung Silizium und/oder Gallium und/oder ein keramisches Material, insbesondere ein Perovskitmaterial auf und die Aufnahmeschicht besteht bevorzugt aus einer Polymerschicht, wobei die Polymerschicht und/oder die Halteschicht zumindest teilweise und bevorzugt vollständig oder zu mehr als 75% aus Polydimethylsiloxane (PDMS) bestehen, wobei die Halteschicht an einer zumindest abschnittsweise ebenen Fläche einer Stabilisierungseinrichtung angeordnet ist, die zumindest teilweise aus mindestens einem Metall besteht. Die Stabilisierungseinrichtung ist bevorzugt eine Platte, insbesondere eine Platte die Aluminium aufweist oder daraus besteht. Diese Ausführungsform ist vorteilhaft, da durch die Stabilisierungseinrichtung und die Halteschicht der Festkörper definiert bzw. fest gehalten wird, wodurch die Spannungen sehr genau in dem Festkörper erzeugt werden können.

Gemäß einer weiteren bevorzugten Ausführungsform der vorliegenden Erfindung sind die Spannungen in dem Festkörper derart einstellbar bzw. erzeugbar, dass die Rissauslösung und/oder die Rissausbreitung zum Erzeugen einer Topografie der sich in der Rissebene ergebenden Oberfläche steuerbar sind. Die Spannungen sind somit bevorzugt in unterschiedlichen Bereichen des Festkörpers bevorzugt zumindest zeitweise unterschiedlich stark erzeugbar. Diese Ausführungsform ist vorteilhaft, da durch Steuerung der Rissauslösung und/oder des Rissverlaufs die Topografie der erzeugten bzw. abgetrennten Festkörperschicht vorteilhaft beeinflussbar ist.

Der Festkörper weist bevorzugt ein Material oder eine Materialkombination aus einer der Hauptgruppen 3, 4 und 5 des Periodensystems der Elemente auf, wie z.B. Si, SiC, SiGe, Ge, GaAs, InP, GaN, Al2O3 (Saphir), AIN. Besonders bevorzugt weist der Festkörper eine Kombination aus in der dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann der Festkörper eine Keramik (z.B. Al2O3 - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Der Festkörper weist somit bevorzugt ein Halbleitermaterial oder ein Keramikmaterial auf bzw. besonders bevorzugt besteht der Festkörper aus mindestens einem Halbleitermaterial oder einem Keramikmaterial. Es ist weiterhin denkbar, dass der Festkörper ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAlSb, Hochtemperatursupraleiter, insbesondere seltene Erden Cuprate (z.B. YBa2Cu3O7).

Ferner offenbart ist ein Wafer, der nach einem Verfahren gemäß einem dei Ansprüche 1 bis 6 hergestellt wird.

Weitere Vorteile, Ziele und Eigenschaften der vorliegenden Erfindung werden anhand nachfolgender Beschreibung anliegender Zeichnungen erläutert, in welchen beispielhaft die erfindungsgemäße Waferherstellung dargestellt ist. Bauteile oder Elemente der erfindungsgemäßen Waferherstellung, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Einzelne oder alle Darstellungen der im Nachfolgenden beschriebenen Figuren sind bevorzugt als Konstruktionszeichnungen anzusehen, d.h. die sich aus der bzw. den Figuren ergebenden Abmessungen, Proportionen, Funktionszusammenhänge und/oder Anordnungen entsprechen bevorzugt genau oder bevorzugt im Wesentlichen denen der erfindungsgemäßen Vorrichtung bzw. des erfindungsgemäßen Produkts.

Darin zeigen:
- Fig. 1a: einen schematischen Aufbau zum Erzeugen von Defekten in einem Festkörper;
- Fig. 1b: eine schematische Darstellung einer Schichtanordnung vor dem Abtrennen einer Festkörperschicht von einem Festkörper;
- Fig. 1c: eine schematische Darstellung einer Schichtanordnung nach dem Abtrennen einer Festkörperschicht von einem Festkörper; und
- Fig. 2: die Abtrennung mehrerer Festkörperschichten von einem Festkörper.

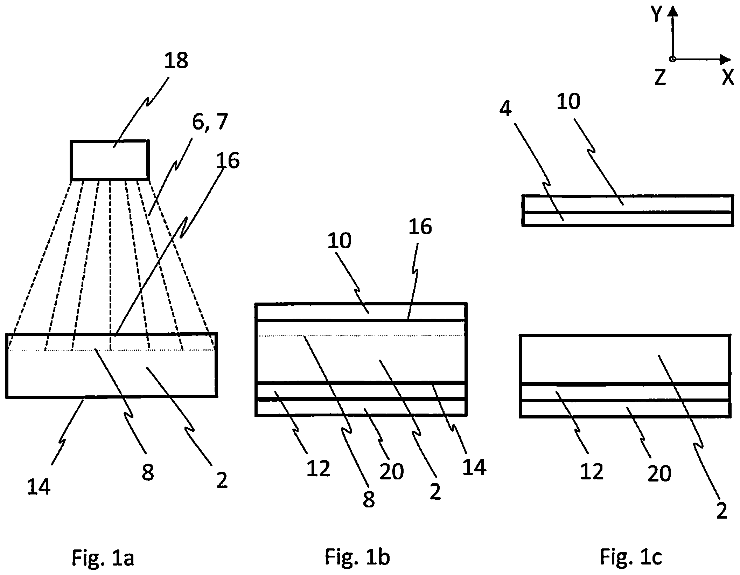

In Fig. 1a ist ein Festkörper 2 bzw. ein Substrat gezeigt, das im Bereich einer Strahlungsquelle 18, insbesondere einem Laser oder eine Ionenkanone, angeordnet ist. Der Festkörper 2 weist bevorzugt einen ersten ebenen Flächenanteil 14 und einen zweiten ebenen Flächenanteil 16 auf, wobei der erste ebene Flächenanteil 14 bevorzugt im Wesentlichen oder genau parallel zu dem zweiten ebenen Flächenanteil 16 ausgerichtet ist. Der erste ebene Flächenanteil 14 und der zweite ebene Flächenanteil 16 begrenzen bevorzugt den Festkörper 2 in einer Y-Richtung, die bevorzugt vertikal bzw. lotrecht ausgerichtet ist. Die ebenen Flächenanteile 14 und 16 erstrecken sich bevorzugt jeweils in einer X-Z-Ebene, wobei die X-Z-Ebene bevorzugt horizontal ausgerichtet ist. Weiterhin lässt sich dieser Darstellung entnehmen, dass die Strahlungsquelle 18 Ionen 6 oder Stahlen 7 auf den Festkörper 2 ausstrahlt. Wenn Die Strahlungsquelle 18 als lonenquelle 6 ausgebildet ist, dann dringen die Ionen 6 je nach Konfiguration definiert tief in den Festkörper 2 ein und verbleiben dort. Sollte die Strahlungsquelle 18 als Laser ausgebildet sein, dann dringen die Strahlen 6 bzw. Lichtwellen in den Festkörper ein und erzeugen an einer vorbestimmten Position einen Defekt.

In Fig. 1b ist eine mehrschichtige Anordnung gezeigt, wobei der Festkörper 2 die Ablöseebene 8 beinhaltet und im Bereich des ersten ebenen Flächenanteils 14 mit einer Halteschicht 12 versehen ist, die wiederum bevorzugt von einer weiteren Schicht 20 überlagert wird, wobei die weitere Schicht 20 bevorzugt eine Stabilisierungseinrichtung, insbesondere eine Metallplatte, ist. An dem zweiten ebenen Flächenanteil 16 des Festkörpers 2 ist bevorzugt eine Polymerschicht 10 angeordnet. Die Polymerschicht 10 und/oder die Halteschicht 12 bestehen bevorzugt zumindest teilweise und besonders bevorzugt vollständig aus PDMS.

In Fig. 1c ist ein Zustand nach einer Rissauslösung und anschließender Rissführung gezeigt. Die Festkörperschicht 4 haftet an der Polymerschicht 10 und ist von dem verbleibenden Rest des Festkörpers 2 beabstandet bzw. beabstandbar. Vor oder nach einer weiteren Einbringung bzw. Erzeugung eines Defekts innerhalb des Festkörpers 2 erfolgt bevorzugt eine weitere Aufbringung einer weiteren Polymerschicht auf die durch die Abspaltung der ersten Festkörperschicht 4 freigelegte Oberfläche des Festkörpers 2. Bevorzugt wird nach jeder Abtrennung einer Festkörperschicht 4, 5 von dem Festkörper 2 eine Polymerschicht auf die freigelegte Oberfläche des Festkörpers 2 aufgebracht, insbesondere solange die Restdicke des Festkörpers 2 noch für eine Trennung in zwei Wafer geeignet ist.

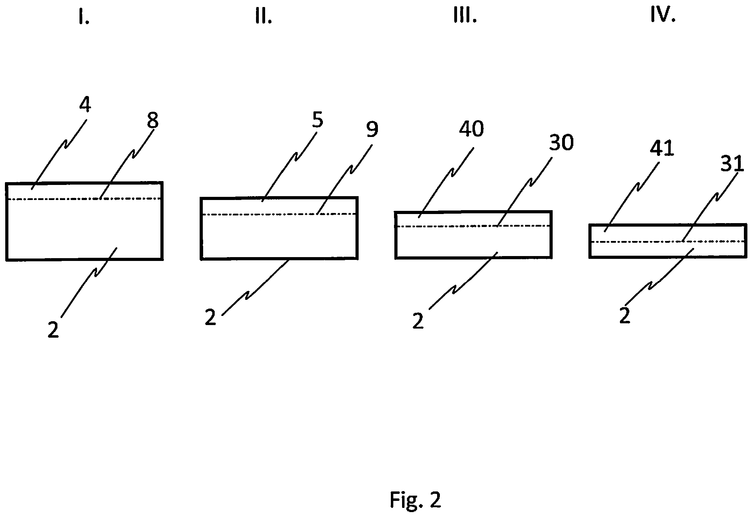

In Fig. 2 sind vier verschiedene schematische Darstellungen eines Festkörpers 2 gezeigt. Der Festkörper 2 weit in jeder Darstellung eine andere axiale Länge (in Y-Richtung) auf. Die Länge des Festkörpers 2 verändert sich ausgehend von der Darstellung I. hin zur Darstellung IV. derart, dass sie immer kürzer wird, da von I.-IV. stets eine Festkörperschicht 4, 5, 40 abgetragen wird. D.h., dass der in II. gezeigte Festkörper 2 um die in I. gezeigte Festkörperschicht 4 verkürzt ist, da diese erste Festkörperschicht 4 entlang der Ablöseebene 8 abgetrennt bzw. abgelöst wurde. In IV. bildet der Festkörper 2 eine Länge aus, die bevorzugt bzw. im Wesentlichen die Auftrennung in zwei Festkörperschichten erlaubt, die bevorzugt eine vergleichbare Länge (in Y-Richtung) aufweisen, wie die zuvor vom Festkörper 2 abgetrennten Festkörperschichten 4, 5.

Es ist hierbei denkbar, dass der Festkörper 2 nach der Abtrennung einer Festkörperschicht 4 mit einem Schleifverfahren behandelt wird, wodurch ebenfalls eine axiale Längenreduzierung des Festkörpers erfolgt. Die durch das Schleifen bewirkte axiale Längenreduzierung des Festkörpers 2 ist der Darstellung jedoch nicht zu entnehmen.

Die Erfindung bezieht sich somit auf ein Verfahren zum Herstellen von Festkörperschichten 4. Das Herstellungsverfahren umfasst dabei bevorzugt mindestens die Schritte: Bereitstellen eines Festkörpers 2 zum Abspalten von mehreren Festkörperschichten 4, Einbringen oder Erzeugen von Defekten in den Festkörper 2 zum Vorgeben einer ersten Ablöseebene 8, entlang der eine erste Festkörperschicht 4 vom Festkörper 2 abgetrennt wird, Anordnen einer Aufnahmeschicht 10 zum Halten der Festkörperschicht 4 an dem Festkörper 2, thermisches Beaufschlagen der Aufnahmeschicht 10 zum, insbesondere mechanischen, Erzeugen von Spannungen in dem Festkörper 2, wobei sich durch die Spannungen ein Riss in dem Festkörper 2 entlang der Ablöseebene 8 ausbreitet, der die erste Festkörperschicht 4 von dem Festkörper 2 abtrennt, Anordnen einer zweiten Aufnahmeschicht zum Halten einer weiteren Festkörperschicht 5 an dem Festkörper 2, Einbringen oder Erzeugen von Defekten in den Festkörper 2 zum Vorgeben einer zweiten Ablöseebene 9, entlang der eine zweite Festkörperschicht 5 vom Festkörper 2 abgetrennt wird, thermisches Beaufschlagen der zweiten Aufnahmeschicht zum, insbesondere mechanischen, Erzeugen von Spannungen in dem Festkörper 2, wobei sich durch die Spannungen ein Riss in dem Festkörper 2 entlang der zweiten Ablöseebene 9 ausbreitet, der die zweite Festkörperschicht 5 von dem Festkörper 2 abtrennt.

### Bezugszeichenliste

- 2: Festkörper
- 4: erste Festkörperschicht
- 5: zweite Festkörperschicht
- 6: Ionen
- 7: Strahlen
- 8: erste Ablöseebene
- 9: zweite Ablöseebene
- 10: Polymerschicht
- 12: Halteschicht
- 14: erster ebener Flächenanteil
- 16: zweiter ebener Flächenanteil
- 18: Strahlungsquelle
- 20: Stabilisierungseinrichtung
- 30: weitere Ablöseebene
- 31: noch weitere Ablöseebene
- 40: weitere Festkörperschicht
- 41: noch weitere Festkörperschicht
- X: erste Richtung
- Y: zweite Richtung
- Z: dritte Richtung

## Patentansprüche

1. Verfahren zum Herstellen von Festkörperschichten,
mindestens umfassend die Schritte:
Bereitstellen eines Festkörpers (2) zum Abspalten von mehreren Festkörperschichten (4), wobei der Festkörper (2) einen ersten ebenen Flächenanteil (14) und einen zweiten ebenen Flächenanteil (16) aufweist,
Einbringen oder Erzeugen von Defekten in den Festkörper (2) mittels Laserstrahlen (7) zum Vorgeben einer ersten Ablöseebene (8), entlang der eine erste Festkörperschicht (4) vom Festkörper (2) abgetrennt wird, wobei die Laserstrahlen über den zweiten ebenen Flächenanteil (16) in den Festkörper (2) eindringen,
Anordnen einer Aufnahmeschicht (10) zum Halten der Festkörperschicht (4) an dem zweiten ebenen Flächenanteil (16) des Festkörpers (2), wobei die Aufnahmeschicht (10) als Polymerschicht ausgebildet ist,
thermisches Beaufschlagen der Aufnahmeschicht (10) zum, insbesondere mechanischen, Erzeugen von Spannungen in dem Festkörper (2), wobei die thermische Beaufschlagung ein Abkühlen der Aufnahmeschicht auf eine Temperatur unterhalb der Umgebungstemperatur darstellt, wobei die Abkühlung derart erfolgt, dass die Polymerschicht einen Glasübergang vollzieht und wobei sich durch die Spannungen ein Riss in dem Festkörper (2) entlang der Ablöseebene (8) ausbreitet, der die erste Festkörperschicht (4) von dem Festkörper (2) abtrennt,
Einbringen oder Erzeugen von Defekten in den Festkörper (2) zum Vorgeben einer zweiten Ablöseebene (9), entlang der eine zweite Festkörperschicht (5) vom Festkörper (2) abgetrennt wird,
anschließendes Anordnen einer zweiten Aufnahmeschicht zum Halten einer weiteren Festkörperschicht (5) an dem um die erste Festkörperschicht (4) reduzierten Festkörper (2), thermisches Beaufschlagen der zweiten Aufnahmeschicht zum, insbesondere mechanischen, Erzeugen von Spannungen in dem Festkörper (2), wobei sich durch die Spannungen ein Riss in dem Festkörper (2) entlang der zweiten Ablöseebene (9) ausbreitet, der die zweite Festkörperschicht (5) von dem Festkörper (2) abtrennt.

2. Verfahren nach Anspruch 1,
**dadurch gekennzeichnet, dass**
nach dem Schritt des thermischen Beaufschlagens der Polymerschicht zum Erzeugen von Spannungen zum Ablösen der ersten Festkörperschicht (4) und vor dem Schritt des Einbringens oder Erzeugens von Defekten in den Festkörper (2) zum Vorgeben einer zweiten Ablöseebene (9) eine spanende Bearbeitung der durch das Abtrennen der ersten Festkörperschicht (4) freigelegten Oberfläche des Festkörpers (2) erfolgt.

3. Verfahren nach einem der Ansprüche 1 oder 2,
**dadurch gekennzeichnet, dass**
die Erzeugung von Defekten durch mindestens eine als Laser ausgeführte Strahlenquelle (18) bewirkt wird, wobei die von der Strahlenquelle ausgestrahlten Strahlen (7) die Defekte an vorbestimmten Orten innerhalb des Festkörpers (2) erzeugen.

4. Verfahren nach Anspruch 3,
**dadurch gekennzeichnet, dass**
die Strahlungsquelle (18) derart eingestellt wird, dass die von ihr ausgestrahlten Strahlen (6) zum Erzeugen der Ablöseebene (8) auf eine definierte Tiefe von weniger als 100µm und bevorzugt von weniger als 50µm und besonders bevorzugt von weniger als 20µm in den Festkörper (2) eindringen.

5. Verfahren nach einem der vorangegangenen Ansprüche,
**dadurch gekennzeichnet, dass**
der Festkörper (2) Silizium und/oder Gallium und/oder ein keramisches Material aufweist und die Aufnahmeschicht aus einer Polymerschicht (10) besteht, wobei die Polymerschicht und/oder die Halteschicht (12) zumindest teilweise aus PDMS bestehen, wobei die Halteschicht (12) an einer zumindest abschnittsweise ebenen Fläche einer Stabilisierungseinrichtung (20) angeordnet ist, die zumindest teilweise aus mindestens einem Metall besteht.

6. Verfahren nach einem der vorangegangenen Ansprüche,
**dadurch gekennzeichnet, dass**
die Spannungen in dem Festkörper (2) derart einstellbar sind, dass die Rissauslösung und/oder die Rissausbreitung zum Erzeugen einer definierten Topografie der sich in der Rissebene ergebenden Oberfläche steuerbar ist.

## Claims

1. Method for producing solid-body layers, comprising at least the following steps:
providing a solid body (2) for splitting off a number of solid-body layers (4), wherein the solid body (2) has a first level surface portion (14) and a second level surface portion (16),
introducing or creating defects in the solid body (2) by means of laser beams (7) for predefining a first detachment plane (8), along which a first solid-body layer (4) is removed from the solid body (2), wherein the laser beams penetrate into the solid body (2) via the second level surface portion (16),
arranging a receiving layer (10) for holding the solid-body layer (4) on the second level surface portion (16) of the solid body (2), wherein the receiving layer (10) is formed as a polymer layer,
applying heat to the receiving layer (10) for creating stresses in the solid body (2), in particular mechanically, wherein the application of heat comprises cooling of the receiving layer to a temperature below the ambient temperature, the cooling taking place in such a way that the polymer layer undergoes a glass transition, and wherein, due to the stresses, a crack spreads along the detachment plane (8) in the solid body (2) and removes the first solid-body layer (4) from the solid body (2),
introducing or creating defects in the solid body (2) for predefining a second detachment plane (9), along which a second solid-body layer (5) is removed from the solid body (2),
then arranging a second receiving layer for holding another solid-body layer (5) on the solid body (2) reduced by the first solid-body layer (4), and
applying heat to the second receiving layer for creating stresses in the solid body (2), in particular mechanically, wherein, due to the stresses, a crack spreads along the second detachment plane (9) in the solid body (2) and removes the second solid-body layer (5) from the solid body (2).

2. Method according to Claim 1,
**characterized in that**,
after the step of applying heat to the polymer layer for creating stresses for detaching the first solid-body layer (4) and before the step of introducing or creating defects in the solid body (2) for predefining a second detachment plane (9), a machining of the surface of the solid body (2) that is exposed by the removal of the first solid-body layer (4) is performed.

3. Method according to either of Claims 1 and 2,
**characterized in that**
the creation of defects is brought about by at least one radiation source (18) formed as a laser, wherein the beams (7) emitted by the radiation source create the defects at predetermined locations within the solid body (2).

4. Method according to Claim 3,
**characterized in that**
the radiation source (18) is set in such a way that the rays (6) emitted by it for creating the detachment plane (8) penetrate into the solid body (2) to a defined depth of less than 100 µm, preferably of less than 50 µm and particularly preferably of less than 20 µm.

5. Method according to one of the preceding claims,
**characterized in that**
the solid body (2) comprises silicon and/or gallium and/or a ceramic material and the receiving layer consists of a polymer layer (10), wherein the polymer layer and/or the holding layer (12) consist at least partially of PDMS, the holding layer (12) being arranged on an at least partially level surface of a stabilization device (20), which consists at least partially of at least one metal.

6. Method according to one of the preceding claims,
**characterized in that**
the stresses in the solid body (2) can be set in such a way that the initiation of the crack and/or the spreading of the crack can be controlled to generate a defined topography of the surface that is obtained in the crack plane.

## Revendications

1. Procédé de production de couches de corps solide, comprenant au moins les stades :
on se procure un corps (2) solide pour la séparation de plusieurs couches (4) de corps solide, le corps (2) solide ayant une première partie (14) de surface plane et une deuxième partie (16) de surface plane,
on insère ou on produit des défauts dans le corps (2) solide au moyen d'un faisceau (7) laser pour prescrire un premier plan (8) de délaminage suivant lequel une première couche (4) de matière solide est séparée du corps (2) solide, le faisceau laser pénétrant dans le corps (2) solide par la deuxième partie (16) de surface plane,
on met une couche (10) de réception pour le maintien de la couche (4) du corps solide sur la deuxième partie (16) de surface plane du corps (2) solide, la couche (10) de réception étant constituée sous la forme d'une couche polymère,
on soumet à un traitement thermique la couche (10) de réception pour la production, notamment mécanique, de tensions dans le corps (2) solide, la soumission à un trait thermique constituant un refroidissement de la couche de réception à une température en-dessous de la température ambiante, le refroidissement s'effectuant de manière à ce que la couche polymère subisse une transition à l'état vitreux et dans lequel, par les tensions, il se propage, suivant le plan (8) de délaminage dans le corps (2) solide, une fissure, qui sépare du corps (2) solide la première couche (4) du corps solide,
on insère ou on produit des défauts dans le corps (2) solide pour prescrire un deuxième plan (9) de délaminage, suivant lequel une deuxième couche (5) du corps solide est séparée du corps (2) solide,
on met ensuite une deuxième couche de réception pour maintenir une autre couche (5) du corps solide sur le corps (2) solide réduit de la première couche (4) du corps solide,
on soumet à un traitement thermique la deuxième couche de réception pour la production, notamment, mécanique de tensions dans le corps (2) solide, dans lequel il se propage, dans le corps (2) solide suivant le deuxième plan (9) de délaminage, par les tensions, une fissure, qui sépare du corps (2) solide la deuxième couche (5) du corps solide.

2. Procédé suivant la revendication 1
**caractérisé en ce que**
après le stade de soumission à un traitement thermique de la couche polymère pour produire des tensions pour séparer la première couche (4) du corps solide et avant le stade de l'insertion ou de la production de défauts dans le corps (2) solide pour prescrire un deuxième plan (9) de délaminage, on effectue un traitement avec enlèvement de copeaux de la surface du corps (2) solide mis à découvert par la séparation de la première couche (4) du corps solide.

3. Procédé suivant la revendication 1 ou 2,
**caractérisé en ce que**
l'on provoque la production de défauts par au moins une source (18) de rayonnement réalisée sous la forme d'un laser, les faisceaux (7) émis par la source de rayonnement produisant les défauts en des emplacements déterminés à l'avance au sein du corps (2) solide.

4. Procédé suivant la revendication 3,
**caractérisé en ce que**
l'on règle la source (18) de rayonnement de manière à ce que les faisceaux (6) qu'elle rayonne pénètrent, pour la production du plan (8) de délaminage, jusqu'à une profondeur définie de moins de 100µm et, de préférence, de moins de 50µm et, d'une manière particulièrement préférée, de moins de 20µm dans le corps (2) solide.

5. Procédé suivant l'une des revendications précédentes,
**caractérisé en ce que**
le corps (2) solide comporte du silicium et/ou du gallium et/ou un matériau céramique et la couche de réception est en une couche (10) polymère, la couche polymère et/ou la couche (12) de maintien étant au moins en partie en PDMS, la couche (12) de maintien étant disposée sur une surface plane, au moins par endroit, d'un dispositif (20) de stabilisation constitué, au moins en partie, en au moins un métal.

6. Procédé suivant l'une des revendications précédentes,
**caractérisé en ce que**
les tensions dans le corps (2) solide sont réglables, de manière à pouvoir commander le déclenchement d'une fissure et/ou la propagation d'une fissure, afin de produire une topographie définie de la surface qui s'ensuit dans le plan de fissure.
